Europäisches Patentamt

European Patent Office

Office européen des brevets

(19)

(11) Publication number : **0 504 959 B1**

(12) **EUROPEAN PATENT SPECIFICATION**

(45) Date of publication of patent specification :
26.07.95 Bulletin 95/30

(51) Int. Cl.$^6$ : **H01L 21/318,** C30B 23/02,
C23C 16/34, C23C 16/36,
C01B 21/06

(21) Application number : **92200541.8**

(22) Date of filing : **26.02.92**

(54) **Carbon-alloyed cubic boron nitride films.**

(30) Priority : **18.03.91 US 670823**

(43) Date of publication of application :
**23.09.92 Bulletin 92/39**

(45) Publication of the grant of the patent :
**26.07.95 Bulletin 95/30**

(84) Designated Contracting States :
**DE GB IT NL**

(56) References cited :
**EP-A- 0 432 820
DE-A- 3 810 237
DE-A- 4 016 352
US-A- 4 961 958
ELECTRONICS LETTERS. vol. 25, no. 23, 9
November 1989, ENAGE GB pages 1602 -1603;
PAUL ET AL: 'Laser-assisted deposition of BN
films on InP for MISapplications'
PATENT ABSTRACTS OF JAPAN vol. 13, no.
39 (C-563)27 January 1989**

(73) Proprietor : **GENERAL MOTORS
CORPORATION
General Motors Building
3044 West Grand Boulevard
Detroit Michigan 48202 (US)**

(72) Inventor : **Doll, Gary Lynn
16015 13 Mile
Southfield, MI 48076 (US)**

(74) Representative : **Denton, Michael John et al
Patent Section
1st Floor
Gideon House
28 Chapel Street
Luton Bedfordshire LU1 2SE (GB)**

## Description

This invention generally relates to the formation of thin films of cubic boron nitride. More particularly, this invention relates to a method for forming these thin films of cubic boron nitride film using laser ablation techniques, for example as disclosed in EP-A-0 432 820, which document has an earlier priority date but which was published after the priority date of the present application.

This invention is related to parallel European patent application EP-A-0 504 960, which was filed on the same day as this patent application.

The two hardest materials known are diamond and cubic boron nitride. Because of this, there is considerable research involving both of these materials for applications such as wear-resistant coatings, abrasive coatings and acoustic elements, as well as electronic devices. Currently, however, efforts to grow smooth, homogeneous diamond films on suitable substrates have been unsuccessful, thereby precluding the use of thin films of diamond as wear-resistant coatings or in electronic devices. Accordingly, there is a strong need for a method for forming diamond films.

Alternatively, a cubic form of boron nitride has been grown on silicon wafers by means of a laser ablation technique, as disclosed in European patent application No.0 432 820, entitled "Laser Deposition of Crystalline Boron Nitride Films". With this laser ablation method, single crystal cubic boron nitride films were epitaxially grown on a silicon substrate oriented along the [100] axis, such that the resulting cubic boron nitride films were in epitaxial registry with the underlying silicon substrate.

The cubic boron nitride (BN) material is a most interesting compound derived from the combination of a column III element of the Periodic Classification with a column V element of the Periodic Classification, from both the practical and scientific viewpoints. The boron nitride phase having this cubic crystal structure is particularly useful since it is characterized by many desirable physical properties besides extreme hardness, including high electrical resistivity and high thermal conductivity. In addition, the cubic boron nitride is relatively inert chemically. Because of these properties, this cubic form of the boron nitride is potentially very useful for many applications, including electronic devices, particularly for use at high temperatures.

Therefore, it is clear that the cubic boron nitride has many useful characteristics. However, in order to successfully grow the cubic boron nitride films on the silicon, the crystallographic lattice for the cubic boron nitride must expand to match the lattice constant of the underlying silicon. In particular, the cubic boron nitride films formed on the silicon substrate by the laser ablation method described above, are characterized by a crystallographic lattice constant of approximately 0.384 nanometres as compared to the lattice constant of approximately 0.362 nanometres for bulk cubic boron nitride powder. Thus, the lattice constant for the cubic boron nitride films formed by the laser ablation method is approximately 5 percent larger than the bulk material. Because of this lattice expansion, two cubic boron nitride unit cells can fit along the [110] silicon direction, so as to result in epitaxial registry between the silicon and cubic boron nitride.

Although this lattice expansion brings the cubic boron nitride into crystallographic registry with the underlying single crystal silicon lattice, a large dislocation energy is always associated with a lattice expansion of this magnitude. It is believed that this large dislocation energy may be accommodated by the presence of pin-holes within the film. Without these pin-holes, or some other vehicle for accommodating this large dislocation energy, the cubic phase for boron nitride is energetically unfavourable.

However, the pin-holes present serious engineering problems, particularly within electronic devices formed from these films. One problem is that there is a substantial electrical current leakage through the holes. This effect, as well as other shortcomings, if not corrected, makes the cubic boron nitride a less desirable insulator for a silicon-based electronic device as compared to other materials. In addition, the cubic boron nitride films which are formed on silicon using this laser ablation technique are not as hard as the bulk cubic boron nitride.

Therefore, it would be desirable to alleviate the shortcomings of the prior art and provide a film which simulates the desired physical and electrical characteristics of both diamond and cubic boron nitride. In particular, it would be desirable to provide such a film using the laser ablation techniques described above.

A method for forming thin films of boron nitride according to the present invention is characterised by the features specified in the characterising portion of claim 1.

It is the primary object of this invention to provide a thin film layer of cubic boron nitride which has been appropriately alloyed with carbon.

It is a further object of this invention that such a thin film layer of carbon-alloyed cubic boron nitride should be formed using laser ablation techniques.

In accordance with a preferred embodiment of this invention, these and other objects and advantages are accomplished as follows.

Thin films of carbon-alloyed boron nitride are provided on single crystal silicon substrates. The thin films of carbon-alloyed boron nitride are formed using laser ablation methods.

The thin films of carbon-alloyed boron nitride are formed in the following manner. Firstly a single crystal silicon substrate is provided. The silicon substrate is disposed in proximity to an appropriate target. The target consists of hexagonally-oriented boron nitride which has been alloyed with a predetermined amount of carbon. Alternatively, the target may be formed from boron nitride and a sufficiently high vapour pressure of a carbon-containing gas is employed to react with the boron nitride upon vaporization of the target.

An appropriate laser is used to induce vaporization of the target material. The vaporized material deposits onto a surface of the silicon substrate to form a thin film layer of carbon-alloyed boron nitride.

An inventive feature of this invention is that the thin film layer of carbon-alloyed boron nitride is characterized by a crystallographic lattice constant which can be varied depending upon the desired film composition and processing parameters. Preferably, the carbon-alloyed boron nitride target, and correspondingly also the resulting thin film composition, has a chemical composition of $(BN)_{1-x}C_x$ where x is about 0.2. Alternatively, the target may be formed from boron nitride and a sufficiently high vapour pressure of a carbon-containing gas is used to introduce the carbon into the boron nitride. This particular composition of $(BN)_{1-x}C_x$ results in a crystallographic lattice constant of approximately 0.36 nanometres. The resulting films are hard, electrically-insulating, and adherent to the silicon substrate, and therefore are particularly suitable for wear resistance and semi-conducting applications over a wide range of temperatures.

In addition, it is foreseeable that the carbon-alloyed boron nitride films could be deposited in such a manner so as to form a gradient throughout the film. The chemical composition would be approximately $(BN)_{0.8}C_{0.2}$ at the silicon - boron nitride interface and would gradually decrease to a carbon concentration of zero, so as to provide a pure boron nitride surface for any particular applications where a surface of pure boron nitride is desired. Alternatively, the carbon concentration could be increased to an x value of one for purposes of providing a diamond surface. This concentration gradient within the film would be achieved by varying the target composition and/or the vapour pressure of the carbon-containing gas during the laser ablation process.

Other objects and advantages of this invention will be better appreciated from the detailed description thereof, which follows.

Thin films of carbon-alloyed boron nitride are provided on silicon substrates. The thin films of carbon-alloyed boron nitride are formed using laser ablation methods.

By alloying cubic boron nitride with an appropriate amount of carbon, a cubic ternary compound having the elemental chemical formula, $(BN)_{1-x}C_x$ where x represents the carbon concentration, is achieved. The ternary crystallographic lattice constant can be systematically varied from that of pure cubic boron nitride to that of pure cubic boron carbide, if desired.

The relationship between the cubic ternary compound lattice constant (a) and the carbon concentration (x) is expressed by the following equation:

$$a = 0.362 (1 - x) + 0.356 (x)$$

where 0.362 and 0.356 are the crystallographic lattice constants in nanometres for bulk cubic boron nitride (BN) and bulk diamond, respectively. For x equal to 0.2, or $(BN)_{0.8}C_{0.2}$, a ternary lattice constant, a, equal to 0.36 nanometres is obtained.

A preferred method for forming the preferred carbon-alloyed cubic boron nitride films utilizes laser ablation techniques, such as described in the co-pending European patent application No.0 432 820. Generally, a boron nitride target containing polycrystalline, hexagonally-oriented, pyrolytic boron nitride which has been alloyed and sintered with the preferred amount of carbon $(BN)_{1-x}C_x$ is provided on a rotating turntable and appropriately located in spaced relationship to the single-crystal silicon substrate within a stainless steel 6-way cross-chamber which is evacuated to an appropriately low pressure. The single crystal substrate is heated to a sufficient temperature, approximately 400°C, to ensure good adhesion and crystal growth, and the temperature is maintained during the ablation and deposition process. Higher temperatures up to about 675°C have been utilized, however the resulting films do not exhibit uniform crystallinity throughout. It has been determined that a temperature of up to about 400°C provides the optimum crystallographic results within the film.

Preferably, a KrF excimer laser source operating at an appropriate wavelength and frequency is used as the ablating beam. The laser operates and the ablation occurs in a chamber filled with ultra-high purity nitrogen gas when using the carbon-alloyed boron nitride target. Laser fluencies ranged from about 1.5 to about 5.2 J/cm². The energy emitted from the laser operating at these parameters would be approximately 5 electron volts, which is approximately 20 percent higher than the disassociation energy required for disassociation of the carbon doped boron nitride target.

The thickness of the cubic boron nitride thin films was determined to vary linearly with laser fluence and the number of laser pulses. At a laser fluence of approximately 3.9 J/cm², an average deposition rate of approximately 0.0182 nanometres (0.182 Angstroms) per pulse can be expected. For a 12,000 pulse run and a laser fluency of approximately 1.5 J/cm², a carbon-alloyed cubic boron nitride film having a thickness of approximately 175 nanometres would be produced. Any thickness within practical considerations could be formed with this method.

An equally-preferred method for forming these films is as follows and utilizes the laser ablation method also. The laser is focussed on a boron nitride target and the laser chamber is filled with a sufficiently high vapour pressure of a carbon-containing gas. Upon vaporization of the target, the boron nitride material reacts with the carbon within the gas to form the preferred carbon-alloyed cubic boron nitride material which deposits upon the substrate surface.

In particular, light from an appropriate laser, preferably the KrF laser operating at approximately 248 nanometres with a pulse duration of 22 nanoseconds, was focused on a hexagonal boron nitride target in approximately 6.666 Pa (50 milliTorr) of ultra-high purity nitrogen gas. The laser fluence was 2.9 J/cm$^2$, and the stainless steel reaction chamber was evacuated using a turbomolecular pump capable of a base vacuum level of 133.322x10$^{-7}$ Pa (10$^{-7}$ Torr). Carbon was incorporated in the films by maintaining a high vapour pressure of any conventional, readily-available hydrocarbon species within the chamber. For a 12,000 pulse deposition run, (i.e., approximately 20 minutes at 10 pulses per second), and a substrate temperature of about 675°C, a film approximately 120 nanometres thick was produced.

Auger electron spectroscopy and Rutherford backscattering spectroscopy were used to ascertain the elemental composition of the film. The approximate stoichiometry was determined to be $(BN)_{0.8}C_{0.2}$. Rutherford Backscattering spectroscopy revealed that the films showed some degree of crystallinity. This degree of crystallinity is due to the differences in crystallographic lattice constants between the $(BN)_{0.8}C_{0.2}$ material (0.36 nanometres) and the silicon substrate (0.38 nanometres). In addition, a higher degree of crystallinity is observed when higher temperatures are used during the laser ablation step. It is foreseeable that with an optimization of processing parameters, the films could be produced which are completely epitaxial with the underlying substrate, although the carbon-alloyed cubic boron nitride material would exhibit some degree of crystallographic lattice expansion.

X-ray diffraction analysis was performed on the thin films to determine their crystal structure. An x-ray line was observed from the carbon-alloyed boron nitride film which was grown on the [110] silicon substrate which was indexed to a [111] lattice reflection for a cubic material having a lattice constant of approximately 0.36 nanometres. This correlates to a carbon concentration of x = 0.2 or $(BN)_{0.8}C_{0.2}$. The width of the x-ray diffraction peak correlates to a grain size of approximately 5 nanometres based on the Debye-Scherrer equation for determination.

With this method, the resulting films exhibit excellent scratch-resistance and excellent adherence to the silicon substrates.

The optical band gap for these carbon-alloyed cubic boron nitride films was determined by spectroscopic ellipsometry to be about 4.2 electronVolts. This is consistent with the transparency of the film in the visible region of the spectrum, and the shape of the absorption edge is also consistent with optical absorption involving an indirect band gap. This large band gap energy should make this preferred carbon-alloyed cubic boron nitride compound a superior insulator for high-temperature, silicon-based semiconducting devices. Examples would be heterostructures for light-emitting diodes or semiconducting lasers, as well as other devices.

In addition, with this method the carbon concentration can be systematically varied within the ternary $(BN)_{1-x}C_x$ compound from x = 0.2 to x = 0, or from x = 0.2 to x = 1. With either gradual transition, the carbon-alloyed boron nitride film would act as a buffer layer between the underlying silicon substrate and a cubic boron nitride film or cubic boron carbide film respectively, with minimal stress resulting due to the gradual change in lattice constants throughout the film. This would allow a device to take advantage of the excellent physical properties of cubic boron nitride or cubic boron carbide for electronic, acoustic and tribological applications. It is foreseeable that the concentration could be varied gradually to eliminate the boron nitride completely so as to provide a pure diamond film also.

The carbon composition could be varied by providing a target which is composed of discrete regions, such as a pie-shaped, segmented target wherein each region has a different predetermined concentration of carbon. The laser would then be focussed on each region as necessary to deposit upon the substrate, the carbon-alloyed boron nitride composition having the appropriate carbon concentration. Alternatively, the vapour pressure of the carbon-containing gas would be gradually changed to introduce the desired changes in carbon concentration.

Another alternative method of varying the carbon composition is to use two targets, the first of which is formed from boron nitride which has been alloyed with carbon, and the second of which has a chemical composition having the formula $(BN)_{1-x}C_x$, where $0 \leqq x \leqq 1$. The targets are both disposed in proximity with the silicon substrate and vaporization of a portion of said first target is induced using a pulsed excimer laser, so that the vaporized material of the first target deposits onto a surface of said substrate to form a first thin film layer of a ternary compound having the formula $(BN)_{1-x}C_x$, where $0 < x \leqq 0.2$. Then vaporization of a portion of said second target is induced using a pulsed excimer laser, so that the vaporized material of the second target deposits onto the surface of the first thin film to form a second thin film layer of a ternary compound having the formula $(BN)_{1-x}C_x$, where $0 \leqq x \leqq 1$.

In addition, it is foreseeable that this laser ablation method would be used for deposition of the preferred compound on a more suitable substrate than silicon having a lattice constant near 0.36 nanometres. This would make epitaxial growth of the preferred carbon-alloyed cubic boron nitride films possible.

Illustrative possible substrates include copper with a cubic crystallographic lattice constant of approximately 0.36 nanometres, or diamond which has a crystallographic lattice constant of 0.356 nanometres. The laser ablation methods described above would be employed accordingly to form the preferred films on these substrates.

It is also foreseeable that the laser ablation methods could be used to form the preferred epitaxial carbon-alloyed cubic boron nitride film upon the silicon substrate, and then an alternative deposition method could be used to supplement the growth procedure. An illustrative example of such an alternative method would be metallo-organic chemical vapour deposition (MOCVD) techniques. The MOCVD method could be advantageous in that it is easy to accurately adjust and vary the chemical composition of elements, within the MOCVD chamber, thereby permitting facile changes in composition. Furthermore, the deposition rates are higher with the MOCVD technique than with this laser ablation method, particularly for boron nitride which has a low optical absorption and accordingly a low ablation rate. The material deposited by the MOCVD method would retain the cubic crystallographic registry of the carbon-alloyed cubic boron nitride film deposited by the laser ablation method.

With this method, carbon-alloyed cubic boron nitride films are formed. The films are optically smooth, therefore they may be suitable as wear-resistant, low-friction coatings on mechanical parts such as piston walls and rotating engine parts for example. In addition, the cubic boron nitride-carbide films could also serve as a replacement for diamond coatings. In addition, it is foreseeable that the films would be suitable for use in high-temperature electronic applications, as well as other applications.

Whilst the present invention has been described in terms of preferred embodiments, it is apparent that other forms of this method could be adopted by one skilled in the art, such as by substituting various other chemical elements, or by modifying the process parameters such as the laser or the target composition. Accordingly, the scope of the present invention is to be limited only by the scope of the following claims.

## Claims

1. A method for forming thin films of boron nitride, which method comprises the steps of providing a substrate of silicon within a low-pressure chamber; providing a target of boron nitride in proximity to said silicon substrate, said target being formed from hexagonally-oriented boron nitride which has been alloyed with carbon; inducing vaporization of said target using a pulsed excimer laser operating at parameters sufficient to dissociate and vaporize said target, and depositing the vaporized material onto a surface of said substrate to form a thin film layer of carbon-alloyed cubic boron nitride on said surface, which thin film layer contains boron, nitrogen and carbon and is an electrically-insulating layer.

2. A method for forming thin films of boron nitride according to claim 1, in which the thin film layer of carbon-alloyed cubic boron nitride deposited on said surface has a chemical composition of $(BN)_{1-x}C_x$, where x has a value not greater than 0.2.

3. A method for forming thin films of boron nitride according to claim 2, in which said laser is a KrF excimer laser source.

4. A method for forming thin films of boron nitride according to any one of claims 1 to 3, in which said silicon substrate is oriented essentially throughout along the [110] crystallographic axis of the substrate; and said substrate is heated to a predetermined temperature sufficient to sustain crystal growth.

5. A method for forming thin films of boron nitride according to claim 4, in which said substrate is heated to a temperature not greater than 400°C.

6. A method for forming thin films of boron nitride according to claim 1, in which said target is formed from a number of regions of hexagonally-oriented boron nitride which have been alloyed with carbon, each of which regions contains a carbon-alloyed boron nitride having the formula $(BN)_{1-x}C_x$, where x has a value up to, but not greater than, 0.2, with a different concentration of carbon than in any of the other regions; vaporization of a first region of said target is induced using said pulsed excimer laser; and the vaporized material is deposited upon said substrate to form a first layer on said substrate having the formula $(BN)_{1-x}C_x$, where x is not greater than 0.2, which first layer is substantially free of pin-holes; and vaporization of the other regions of said target is induced selectively using said laser, so that successive layers of material are deposited on said substrate, each layer having a lower concentration of carbon than the previous layer, and so that the top layer deposited is substantially pure cubic boron nitride.

7. A method for forming thin films of boron nitride according to claim 6, in which said successive layers are deposited so that said top layer of substantially pure cubic boron nitride is substantially free of pin-holes.

8. A method for forming thin films of boron nitride according to claim 6, in which said laser is a KrF excimer laser source, and said substrate is heated to a temperature not greater than 400°C.

9. A method for forming thin films of boron nitride according to claim 1, in which the target of carbon-alloyed boron nitride is replaced by a target of boron nitride, and a carbon-containing gaseous material is introduced into said chamber at a vapour pressure which is sufficiently high to cause the vaporized boron nitride from the target to react with said carbon-containing gaseous material to form said thin film layer of carbon-alloyed cubic boron nitride upon said surface.

10. A method for forming thin films of boron nitride according to claim 9, in which the deposited film layer of carbon-alloyed cubic boron nitride on said surface has a chemical composition of $(BN)_{1-x}C_x$, where x is not greater than 0.2, and a lattice constant of about 0.36 nanometres.

11. A method for forming thin films of boron nitride according to claim 9, in which said laser is a KrF excimer laser source, and said substrate is heated to a temperature not greater than 675°C.

12. A method for forming thin films of boron nitride according to claim 9, in which said vapour pressure of said carbon-containing gaseous material is varied during said vaporization of said target so that said deposited film layer of carbon-alloyed cubic boron nitride has a varying chemical composition throughout said film layer, which chemical composition is represented by the chemical formula of $(BN)_{1-x}C_x$, and the carbon concentration x varies from up to about 0.2, at the interface between said carbon-alloyed cubic boron nitride film layer and said substrate, up to about 1 at the opposite surface of said film layer.

13. A method for forming thin films of boron nitride according to claim 1, in which said target comprises two targets, the first of which is formed from boron nitride which has been alloyed with carbon, and the second of which has a chemical composition having the formula $(BN)_{1-x}C_x$, where $0 \leqq x \leqq 1$; said targets are both disposed in proximity with said silicon substrate; vaporization of a portion of said first target is induced using said pulsed excimer laser, and the vaporized material of the first target is deposited onto a surface of said substrate to form a first thin film layer of a ternary compound having the formula $(BN)_{1-x}C_x$, where $x \leqq 0.2$; and vaporization of a portion of said second target is induced using a pulsed excimer laser, and the vaporized material of the second target is deposited onto the surface of the first thin film to form a second thin film layer of a ternary compound having the formula $(BN)_{1-x}C_x$, where $0 \leqq x \leqq 1$.

**Patentansprüche**

1. Verfahren zur Bildung von dünnen Bornitridfilmen, wobei das Verfahren die Stufen der Bereitstellung eines Siliziumsubstrates innerhalb einer Niederdruckkammer, der Bereitstellung eines Bornitridtargets in der Nähe zu diesem Siliziumsubstrat, wobei dieses Target aus hexagonal orientiertem Bornitrid, das mit Kohlenstoff legiert wurde, gebildet ist, der Induzierung der Verdampfung dieses Targets unter Verwendung eines gepulsten Excimerlasers, der bei ausreichenden Parametern zur Dissoziierung und Verdampfung dieses Targets arbeitet, und der Ablagerung des verdampften Materials auf einer Oberfläche dieses Substrates unter Bildung einer dünnen Filmschicht von kohlenstofflegiertem kubischen Bornitrid auf dieser Oberfläche umfaßt, wobei diese dünne Filmschicht Bor, Stickstoff und Kohlenstoff enthält und eine elektrisch isolierende Schicht ist.

2. Verfahren zur Bildung von dünnen Bornitridfilmen nach Anspruch 1, in welchem die dünne Filmschicht aus kohlenstofflegiertem kubischem Bornitrid, die auf dieser Oberfläche abgelagert ist, eine chemische Zusammensetzung von $(BN)_{1-x}C_x$ besitzt, worin x einen Wert nicht größer als 0,2 hat.

3. Verfahren zur Bildung von dünnen Bornitridfilmen nach Anspruch 2, in welchem dieser Laser eine KrF-Excimerlaser-Quelle ist.

4. Verfahren zur Bildung von dünnen Bornitridfilmen nach einem der Ansprüche 1 bis 3, in welchem dieses Siliziumsubstrat im wesentlichen längs der kristallographischen [110]-Achse des Substrates orientiert ist, und dieses Substrat auf eine zur Aufrechterhaltung des Kristallwachstums vorbestimmte Temperatur erhitzt wird.

5. Verfahren zur Bildung von dünnen Bornitridfilmen nach Anspruch 4, in welchem dieses Substrat auf eine Temperatur nicht größer als 400° C erhitzt wird.

6. Verfahren zur Bildung von dünnen Bornitridfilmen nach Anspruch 1, in welchem dieses Target aus einer Anzahl von Bereichen aus hexagonal orientiertem Bornitrid, die mit Kohlenstoff legiert worden sind, gebildet wird, wovon jeder Bereich ein kohlenstofflegiertes Bornitrid mit der Formel $(BN)_{1-x}C_x$, worin x einen Wert bis zu jedoch nicht größer als 0,2 hat, mit einer unterschiedlichen Konzentration von Kohlenstoff als in irgendeinem der anderen Bereiche enthält, die Verdampfung eines ersten Bereiches dieses Targets unter Anwendung dieses gepulsten Excimerlasers induziert wird und das verdampfte Material auf diesem Substrat unter Bildung einer ersten Schicht auf diesem Substrat mit der Formel $(BN)_{1-x}C_x$, worin x nicht größer als 0,2 ist, abgelagert wird, wobei die erste Schicht im wesentlichen frei von feinen Löchern ist, und Verdampfung der anderen Bereiche dieses Targets selektiv unter Anwendung dieses Lasers induziert wird, so daß aufeinanderfolgende Schichten von Material auf diesem Substrat gebildet werden, wovon jede Schicht eine niedrigere Konzentration an Kohlenstoff als die vorangegangene Schicht besitzt und so, daß die abgelagerte oberste Schicht im wesentlichen reines kubisches Bornitrid ist.

7. Verfahren zur Bildung von dünnen Bornitridfilmen nach Anspruch 6, in welchem diese aufeinanderfolgenden Schichten so abgelagert werden, daß diese oberste Schicht aus im wesentlichen reinem kubischen Bornitrid im wesentlichen frei von feinen Löchern ist.

8. Verfahren zur Bildung von dünnen Bornitridfilmen nach Anspruch 6, in welchem dieser Laser eine KrF-Excimerlaser-Quelle ist und dieses Substrat auf eine Temperatur nicht größer als 400° C erhitzt wird.

9. Verfahren zur Bildung von dünnen Bornitridfilmen nach Anspruch 1, in welchem das Target aus kohlenstofflegiertem Bornitrid durch ein Target aus Bornitrid ersetzt wird und ein kohlenstoffhaltiges gasförmiges Material in diese Kammer bei einem ausreichend hohen Gasdruck eingeführt wird, um die Reaktion des aus dem Target verdampften Bornitrids mit diesem kohlenstoffhaltigen gasförmigen Material zu bewirken, um diese dünne Filmschicht aus kohlenstofflegiertem kubischen Bornitrid auf dieser Oberfläche zu bilden.

10. Verfahren zur Bildung von dünnen Bornitridfilmen nach Anspruch 9, in welchem die abgelagerte Filmschicht aus kohlenstofflegiertem kubischen Bornitrid auf dieser Oberfläche eine chemische Zusammensetzung von $(BN)_{1-x}C_x$, worin x einen Wert nicht größer als 0,2 hat, und eine Gitterkonstante von etwa 0,36 nm besitzt.

11. Verfahren zur Bildung von dünnen Bornitridfilmen nach Anspruch 9, in welchem dieser Laser eine KrF-Excimerlaser-Quelle ist und dieses Substrat auf eine Temperatur nicht größer als 675° C erhitzt wird.

12. Verfahren zur Bildung von dünnen Bornitridfilmen nach Anspruch 9, in welchem dieser Dampfdruck dieses kohlenstoffhaltigen gasförmigen Materials während der Verdampfung dieses Targets so variiert wird, daß diese abgelagerte Filmschicht von kohlenstofflegiertem kubischen Bornitrid eine variierende chemische Zusammensetzung innerhalb dieser Filmschicht hat, wobei diese chemische Zusammensetzung durch die Formel $(BN)_{1-x}C_x$ wiedergegeben wird, und die Kohlenstoffkonzentration x von bis zu etwa 0,2 an der Grenzfläche zwischen dieser kohlenstofflegierten kubischen Bornitridfilmschicht und diesem Substrat bis zu etwa 1 an der gegenüberliegenden Oberfläche dieser Filmschicht variiert.

13. Verfahren zur Bildung von dünnen Bornitridfilmen nach Anspruch 1, in welchem dieses Target zwei Targets umfaßt, deren erstes aus Bornitrid besteht, das mit Kohlenstoff legiert worden ist, und deren zweites eine chemische Zusammensetzung mit der Formel $(BN)_{1-x}C_x$ hat, worin $0 \leqq x \leqq 1$, wobei beide Targets in der Nähe zu diesem Siliziumsubstrat angeordnet sind, Verdampfung eines Teiles dieses ersten Targets unter Verwendung dieses gepulsten Excimerlasers induziert wird und das verdampfte Material des ersten Targets auf einer Oberfläche dieses Substrates zur Bildung einer ersten dünnen Filmschicht einer ternären Verbindung mit der Formel $(BN)_{1-x}C_x$, worin $x \leqq 0,2$ ist, abgelagert wird, und Verdampfung eines Teiles dieses zweiten Targets unter Verwendung eines gepulsten Excimerlasers induziert wird, und das verdampfte Material des zweiten Targets auf der Oberfläche des ersten dünnen Filmes zur Bildung einer zweiten dünnen Filmschicht einer ternären Verbindung mit der Formel $(BN)_{1-x}C_x$, worin $0 \leqq x \leqq 1$ ist, abgelagert wird.

**Revendications**

1. Procédé pour former des pellicules fines de nitrure de bore, qui comprend les étapes de mise en place d'un substrat en silicium à l'intérieur d'une chambre sous basse pression ; de mise en place d'une cible de nitrure de bore à proximité dudit substrat en silicium, ladite cible étant formée de nitrure de bore orienté dans le système hexagonal, qui a été allié avec du carbone ; d'induction de la vaporisation de ladite cible en utilisant un laser impulsionnel à excimère avec des paramètres de travail suffisants pour dissocier et vaporiser ladite cible ; et de dépôt du matériau vaporisé sur une surface dudit substrat pour former sur ladite surface une couche pelliculaire fine de nitrure de bore cubique allié avec du carbone , cette couche pelliculaire fine contenant du bore, de l'azote et du carbone et étant une couche d'isolation électrique.

2. Procédé pour former des pellicules fines de nitrure de bore selon la revendication 1, dans lequel la couche pelliculaire fine de nitrure de bore cubique allié avec du carbone, déposée sur ladite surface, a la composition chimique $(BN)_{1-x}C_x$, dans laquelle la valeur de x n'est pas supérieure à 0,2.

3. Procédé pour former des pellicules fines de nitrure de bore selon la revendication 2, dans lequel ledit laser est une source laser à excimère KrF.

4. Procédé pour former des pellicules fines de nitrure de bore selon l'une quelconque des revendications 1 à 3, dans lequel ledit substrat en silicone est orienté essentiellement de part en part selon l'axe cristallographique [110] du substrat ; et ledit substrat est chauffé à une température prédéfinie suffisante pour entretenir la croissance cristalline.

5. Procédé pour former des pellicules fines de nitrure de bore selon la revendication 4, dans lequel ledit substrat est chauffé à une température qui n'est pas inférieure à 400°C.

6. Procédé pour former des pellicules fines de nitrure de bore selon la revendication 1, dans lequel ladite cible est formée d'un certain nombre de régions de nitrure de bore orienté dans le système hexagonal qui a été allié avec du carbone, chacune de ces régions contenant un nitrure de bore allié avec du carbone de formule $(BN)_{1-x}C_x$, dans laquelle x a une valeur pouvant aller jusqu'à, mais ne dépassant pas, 0,2, présentant une concentration en carbone différente de celle de toutes les autres régions ; la vaporisation d'une première région de ladite cible est induite en utilisant un laser impulsionnel à excimère ; et le matériau vaporisé est déposé sur ledit substrat pour former une première couche sur ledit substrat dont la formule est $(BN)_{1-x}C_x$, dans laquelle x n'est pas supérieur à 0,2, cette première couche étant sensiblement exempte de trous d'épingles ; et la vaporisation des autres régions de ladite cible est induite sélectivement en utilisant ledit laser, de sorte que des couches successives de matériau sont déposées sur ledit substrat, chaque couche ayant une concentration en carbone inférieure à celle de la couche précédente, et de telle sorte que la couche supérieure déposée soit du nitrure de bore cubique sensiblement pur.

7. Procédé pour former des pellicules fines de nitrure de bore selon la revendication 6, dans lequel lesdites couches successives sont déposées de telle sorte que ladite couche supérieure de nitrure de bore cubique sensiblement pure soit sensiblement exempte de trous d'épingles.

8. Procédé pour former des pellicules fines de nitrure de bore selon la revendication 6, dans lequel ledit laser est une source laser à excimère KrF et ledit substrat est chauffé à une température qui n'est pas supérieure à 400°C.

9. Procédé pour former des pellicules fines de nitrure de bore selon la revendication 1, dans lequel la cible de nitrure de bore allié avec du carbone est remplacée par une cible de nitrure de bore, et un matériau gazeux contenant du carbone est introduit dans ladite chambre à une pression de vapeur suffisamment élevée pour provoquer une réaction entre le nitrure de bore vaporisé à partir de la cible et ledit matériau gazeux contenant du carbone pour former sur ladite surface ladite couche pelliculaire fine de nitrure de bore cubique allié avec du carbone .

10. Procédé pour former des pellicules fines de nitrure de bore selon la revendication 9, dans lequel la couche pelliculaire de nitrure de bore cubique allié avec du carbone déposée sur ladite surface a la composition chimique $(BN)_{1-x}C_x$, dans laquelle x n'est pas supérieur à 0,2, et a une constante de réseau d'environ 0,36 nanomètres.

11. Procédé pour former des pellicules fines de nitrure de bore selon la revendication 9, dans lequel ledit laser est une source laser à excimère KrF, et ledit substrat est chauffé à une température qui n'est pas supérieure à 675°C.

12. Procédé pour former des pellicules fines de nitrure de bore selon la revendication 9, dans lequel on fait varier ladite pression de vapeur dudit matériau gazeux contenant du carbone pendant ladite vaporisation de ladite cible, de sorte que ladite couche pelliculaire de nitrure de bore cubique allié avec du carbone déposée ait une composition chimique variable de part en part de ladite couche pelliculaire, cette composition chimique étant représentée par la formule chimique $(BN)_{1-x}C_x$, et la concentration en carbone x variant jusqu'à environ 0,2, à l'interface entre la couche pelliculaire de nitrure de bore cubique allié avec du carbone et ledit substrat, jusqu'à environ 1, à la surface opposée de ladite couche pelliculaire.

13. Procédé pour former des pellicules fines de nitrure de bore selon la revendication 1, dans lequel ladite cible comprend deux cibles, la première étant formée de nitrure de bore qui a été allié avec du carbone, et la seconde ayant une composition chimique de formule $(BN)_{1-x}C_x$, dans laquelle $0 \leqq x \leqq 1$ ; lesdites cibles sont disposées toutes les deux à proximité dudit substrat en silicium ; la vaporisation d'une portion de ladite première cible est induite en utilisant un laser impulsionnel à excimère, et le matériau vaporisé de la première cible est déposé sur une surface dudit substrat pour former une première couche pelliculaire fine d'un composé ternaire ayant la formule $(BN)_{1-x}C_x$, dans laquelle $x \leqq 0{,}2$ ; et la vaporisation d'une portion de ladite seconde cible est induite en utilisant un laser impulsionnel à excimère , et le matériau vaporisé de la seconde cible est déposé sur la surface de la première pellicule fine pour former une seconde couche pelliculaire fine d'un composé ternaire ayant la formule $(BN)_{1-x}C_x$, dans laquelle $0 \leqq x \leqq 1$ .